(19) Europäisches Patentamt / European Patent Office / Office européen des brevets

(11) **EP 2 706 578 A1**

(12) **EUROPEAN PATENT APPLICATION**
published in accordance with Art. 153(4) EPC

(43) Date of publication:
**12.03.2014 Bulletin 2014/11**

(21) Application number: **12796808.9**

(22) Date of filing: **08.06.2012**

(51) Int Cl.:
**H01L 31/04** (2014.01)

(86) International application number:
**PCT/JP2012/064799**

(87) International publication number:
**WO 2012/169617 (13.12.2012 Gazette 2012/50)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **10.06.2011 US 201113157885**
**10.06.2011 US 201113157922**

(71) Applicant: **Tokyo Ohka Kogyo Co., Ltd.**
**Kanagawa 211-0012 (JP)**

(72) Inventors:
• **KUWAHARA Masaru**
**Kawasaki-shi, Kanagawa 211-0012 (JP)**
• **MISUMI Koichi**
**Kawasaki-shi, Kanagawa 211-0012 (JP)**
• **MIYAMOTO Hidenori**
**Kawasaki-shi, Kanagawa 211-0012 (JP)**

(74) Representative: **Cabinet Plasseraud**
**52, rue de la Victoire**
**75440 Paris Cedex 09 (FR)**

(54) **HYDRAZINE-COORDINATED Cu CHALCOGENIDE COMPLEX AND METHOD FOR PRODUCING SAME, APPLICATION LIQUID FOR FORMING LIGHT-ABSORBING LAYER, AND METHOD FOR PRODUCING APPLICATION LIQUID FOR FORMING LIGHT-ABSORBING LAYER**

(57) A hydrazine-coordinated Cu chalcogenide complex obtainable by reacting Cu or $Cu_2Se$ and a chalcogen in dimethylsulfoxide in the presence of hydrazine and free of an amine solvent, and adding a poor solvent to the resulting solution or subjecting the resulting solution to concentration and filtration.

FIG. 6

CdS, ZnO, TCO
CZTS: 1005 nm
$MoSe_2$: 96.76nm
Mo + $MoSe_2$: 885.8 nm
Soda-lime glass

EP 2 706 578 A1

**Description**

TECHNICAL FIELD

The present invention relates to a hydrazine-coordinated Cu chalcogenide complex and a method of producing the same.

Priority is claimed on U. S. Patent Application Nos. 13/157,885 and 13/157,922, the contents of which are incorporated herein by reference.

BACKGROUND ART

In recent years, in consideration of environment, solar cells have been attracting a growing interest. In particular, attention has been drawn to chalcopyrite solar cells which are thin-film solar cells with high photoelectric conversion efficiency, and also CZTS solar cells which have a rare metal such as indium used in a chalcopyrite solar cell substituted with another element, and hence, research and development have been actively conducted.

A chalcopyrite solar cell is produced by forming a light absorbing layer prepared from a chalcopyrite material on a substrate. Representative elements of a chalcopyrite material include copper (Cu), indium (In), galium (Ga), selenium (Se) and sulfur (S), and representative examples of a light absorbing layer include $Cu(In, Ga)Se_2$ and $Cu(In, Ga)(Se, S)_2$, which are abbreviated as CIGS and CIGSS, respectively. Recently, CZTS solar cell has been studied in which a rare metal indium has been substituted and is composed of, for example, copper (Cu), zinc (Zn), tin (Sn), selenium (Se) and sulfur (S). Representative examples of the light absorbing layer of such a solar cell include $Cu_2ZnSnSe_4$, $Cu_2ZnSnS_4$ and $Cu_2ZnSn(S, Se)_4$.

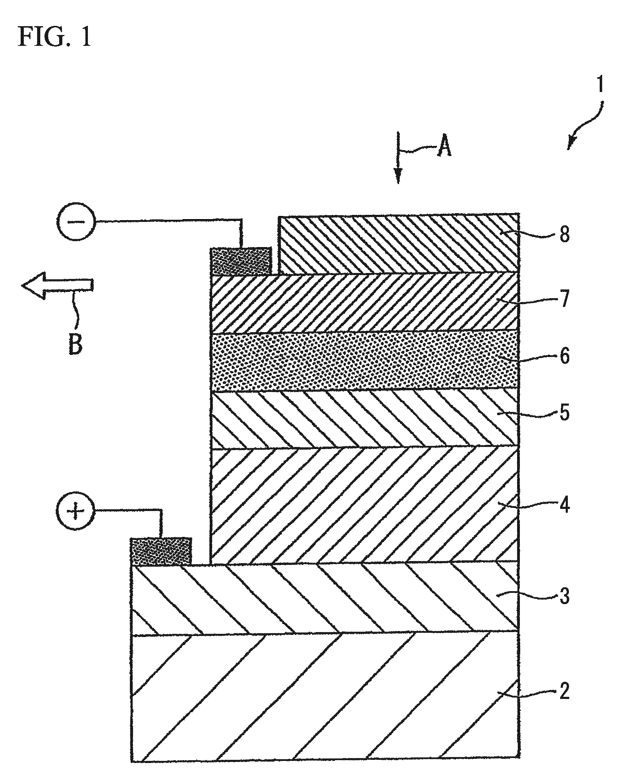

FIG. 1 is a schematic cross-sectional diagram of an example of a chalcopyrite solar cell or a CZTS solar cell.

As shown in FIG. 1, a chalcopyrite solar cell or a CZTS solar cell 1 has a basic structure in which a first electrode 3, a CIGS or CZTS layer 4, a buffer layer5, an i-ZnO layer 6 and a second electrode 7 are laminated on a substrate 2 in this order. As the buffer layer, for example, a CdS layer, an ZnS layer and an InS layer are known.

Each of the first electrode 3 and the second electrode 7 has a terminal connected thereto, and each of the terminals is connected to a wiring. In such a chalcopyrite solar cell or a CZTS solar cell 1, an incident light entering in the direction of A is absorbed by the CIGS or CZTS layer 4 to generate an electromotive force, and an electric current flows in the direction of B.

The surface of the second electrode 7 is, for example, covered with an anti-reflection film layer 8 composed of an $MgF_2$ layer for protection.

As a method of forming a CIGS or CZTS layer 4, a sputtering method and a coating method are known. However, in the sputtering method, the size of the apparatus tends to be scaled up, thereby deteriorating the yield. Therefore, diligent studies have been made on the coating method which enables production at a relatively low cost.

Generally, in a coating method of a CIGS layer, elements such as Cu, In, Ga, Se and S are dissolved in a specific solvent to prepare a coating solution, and the coating solution is applied to a substrate by a spin coating method or a dipping method, followed by baking, thereby forming a CIGS layer (see for example, Patent Document 1 and Patent Document 2).

In the preparation of a coating solution, there are known a method in which hydrazine is used as the solvent, and a method in which amine is added as a dissolution promoter instead of using hydrazine.

DOCUMENTS OF RELATED ART

[Patent Document]

[Patent Document 1] U.S. Patent No. 7,094,651
[Patent Document 2] WO2008/057119
[Patent Document 3] WO2008/063190
[Patent Document 4] U.S. Patent No. 7,517,718
[Patent Document 5] U.S. Patent No. 7,341,917
[Patent Document 6] U.S. Patent No. 7,618,841
[Patent Document 7] U.S. Publication No. 2009/0145482

## SUMMARY OF THE INVENTION

[Problems to be Solved by the Invention]

However, in the preparation of a coating solution, when hydrazine is used as the solvent, a problem has conventionally been raised in terms of safety of the process due to chemical properties (explosiveness) of hydrazine.

Further, when hydrazine is used as the coating solvent, a problem arises in that copper selenide ($Cu_2Se$) is precipitated after about 2 weeks from the preparation of the coating solution, such that the storage period of the coating solution becomes short.

In view of these problems, there have been demands for a coating solution which can assure safety of process and have storage stability over a long time. However, such a coating solution has not been proposed under these circumstances.

[Means to Solve the Problems]

For solving the above-mentioned problems, the present invention employs the following embodiments.

A first aspect of the present invention is a hydrazine-coordinated Cu chalcogenide complex is obtainable by reacting Cu or $Cu_2Se$ and a chalcogen in dimethylsulfoxide in the presence of hydrazine and free of an amine solvent, and adding a poor solvent to the resulting solution or subjecting the resulting solution to concentration and filtration.

Further, a second aspect of the present invention is a method of producing a hydrazine-coordinated Cu chalcogenide complex including: reacting Cu or $Cu_2Se$ and a chalcogen in dimethylsulfoxide in the presence of hydrazine and free of an amine solvent, and adding a poor solvent to the resulting solution or subjecting the resulting solution to concentration and filtration.

A third aspect of the present invention is a coating solution for forming a light-absorbing layer of a chalcopyrite solar cell, including: a hydrazine-coordinated Cu chalcogenide complex, a hydrazine-coordinated In chalcogenide complex and a hydrazine-coordinated Ga chalcogenide complex dissolved in dimethylsulfoxide.

A fourth aspect of the present invention is a method of producing a coating solution forming a light-absorbing layer of a chalcopyrite solar cell, the method including: dissolving a hydrazine-coordinated Cu chalcogenide complex of the first aspect, a hydrazine-coordinated In chalcogenide complex and a hydrazine-coordinated Ga chalcogenide complex in dimethylsulfoxide.

[Effect of the Invention]

In the present invention, a hydrazine-coordinated Cu chalcogenide complex and a DMSO solution are provided which are usable for forming a light-absorbing layer of a chalcopyrite solar cell or a CZTS solar cell. Therefore, when coating is performed in the formation of a light-absorbing layer of a chalcopyrite solar cell or a CZTS solar cell, there is no need to use dangerous hydrazine in the application of the coating solution. As a result, safety of the process in the formation of a light-absorbing layer can be assured.

Further, in the present invention, since Cu, In and Ga are dissolved in not hydrazine but dimethylsulfoxide (DMSO), there is no need to use dangerous hydrazine in the application of the coating solution. As a result, safety of the process in the formation of a light-absorbing layer can be assured. Further, the coating solution for forming a light-absorbing layer according to the present invention has no precipitation of $Cu_2Se$. Therefore, the coating solution exhibits an excellent storage stability.

## BRIEF DESCRIPTION OF THE DRAWINGS

FIG. 1 is a schematic cross-sectional diagram of an example of a chalcopyrite solar cell or a CZTS solar cell.
FIG. 2 is the results of thermogravimetric analysis of the hydrazine-coordinated Cu chalcogenide complex produced in Example 1.
FIG. 3 is the results of X-ray diffraction analysis of the residue obtained from the thermogravimetric analysis of the hydrazine-coordinated Cu chalcogenide complex produced in Example 1.
FIG. 4 is the results of X-ray diffraction analysis following formation of a film in Example 1.
FIG. 5 is the results of X-ray diffraction analysis following formation of a film in Example 2.
FIG. 6 is a cross-sectional diagram of the CZTS layer formed in Example 2 as measured by a scanning electron microscope.

DETAILED DESCRIPTION OF THE INVENTION

[Hydrazine-coordinated Cu chalcogenide complex]

Hereinbelow, the hydrazine-coordinated Cu chalcogenide complex of the present invention will be described.
The hydrazine-coordinated Cu chalcogenide complex is obtainable by reacting Cu or $Cu_2Se$ and a chalcogen in dimethylsulfoxide in the presence of hydrazine and free of an amine solvent, and adding a poor solvent to the resulting solution or subjecting the resulting solution to concentration and filtration.
More specifically, for example, a Cu metal and a chalcogen are reacted in DMSO in the presence of hydrazine, and stirred at room temperature for about 3 to 7 days. Then, hydrazine is removed from the resulting solution while flowing nitrogen, followed by filtration. Thereafter, a poor solvent is added to the filtrate to perform a recrystallization, thereby obtaining a black hydrazine-coordinated Cu chalcogenide complex.
Alternatively, the hydrazine-coordinated Cu chalcogenide complex of the present invention can be produced as follows. A metal Cu and 2 to 4 equivalents of Se are stirred in DMSO at room temperature for 3 days to 1 week in the presence of 2 equivalents of hydrazine relative to the Cu metal. Then, the remaining hydrazine is removed under reduced pressure, followed by concentration. The resulting concentrated solution is subjected to filtration, thereby obtaining a hydrazine-coordinated Cu-Se complex/DMSO solution.
As the chalcogen, Se or S can be used, and Se is preferable. As Cu, not only a Cu metal, but also copper selenide ($Cu_2Se$) may be used. As the poor solvent, an alcohol solvent is preferable, and isopropanol (IPA) is more preferable.
As hydrazine, anhydrous hydrazine may be used, although hydrazine monohydrate or hydrazine having water added thereto (hereafter, referred to as "water-containing hydrazine") is preferable. Anhydrous hydrazine vigorously reacts with selenium, whereas hydrazine monohydrate or a water-containing hydrazine mildly reacts with selenium. Therefore, hydrazine monohydrate or a water-containing hydrazine is preferable in terms of ease in handling in the synthesis process. The water content of the water-containing hydrazine is preferably 63% by weight or more.
With respect to the amount of Cu and the chalcogen, it is preferable to use 2 to 4 mol of the chalcogen, per 1 mol of Cu. Further, it is preferable to dissolve Cu and the chalcogen in DMSO having about 2 mol of hydrazine added thereto.
The generation of the hydrazine-coordinated Cu chalcogenide complex described above can be expressed by a chemical formula (1) shown below.

$$Cu \ + \ 2\text{~}4\,Se \ + \ 2\,N_2H_4 \ \xrightarrow[\text{r.t. for few days}]{\text{DMSO}} \ \begin{array}{c} \text{Hydrazinium} \\ \text{Cu-Se precursor} \end{array} \quad (1)$$

As described above, the hydrazine-coordinated Cu chalcogenide complex of the present invention is obtained by dissolving the raw materials in DMSO, followed by recrystallization. As a result, the thus obtained hydrazine-coordinated Cu chalcogenide complex is extremely soluble in a DMSO solution.
Further, with respect to the hydrazine-coordinated Cu chalcogenide complex of the present invention, since the coating solvent does not contain hydrazine, the chemical properties (explosiveness) of hydrazine in the formation of a light-absorbing layer would not be of any problems, thereby improving the safety of the production process.
In addition, since the hydrazine-coordinated Cu chalcogenide complex of the present invention contains no amines as a dissolution promoter, the PV performance is improved as compared to conventional coating solutions.
For the reasons as described above, the hydrazine-coordinated Cu chalcogenide complex of the present invention is extremely useful as a Cu component of a coating solution for forming a CIGS or CZTS layer.

[Coating solution for forming light absorbing later (coating solution for forming CIGS layer)]

[First embodiment]

Hereafter, the coating solution for forming a light absorbing layer according to the present invention will be described.
The coating solution for forming a light absorbing layer according to the present invention (hereafter, referred to as "coating solution for forming CIGS layer") is obtainable by dissolving a hydrazine-coordinated Cu chalcogenide complex according to the first aspect, a hydrazine-coordinated In chalcogenide complex and a hydrazine-coordinated Ga chalcogenide complex in dimethylsulfoxide (DMSO).
The coating solution forming a light-absorbing layer is preferably free of amine solvents.

Next, the hydrazine-coordinated In chalcogenide complex will be described. The hydrazine-coordinated In chalcogenide complex used in this embodiment is required to be generated so as to be soluble in DMSO. The hydrazine-coordinated In chalcogenide complex can be generated, for example, by adding In selenide ($In_2Se_3$) and a chalcogen in hydrazine to obtain a crude product (a first crude product), extracting the crude product with DMSO, adding a poor solvent to the resulting solution, followed by reprecipitation.

More specifically, In selenide and a chalcogen are added to hydrazine, and stirred at room temperature for about 3 to 7 days. Then, hydrazine is removed from the resulting solution while flowing nitrogen to obtain a crude product. Thereafter, the obtained crude product is extracted with DMSO.

Subsequently, the extraction liquid obtained by extracting the crude product is subjected to filtration using, for example, a 0.2 $\mu$m PTFE filter, followed by concentration. Then, a poor solvent is added to the concentrated solution to perform a reprecipitation, and the supernatant is removed. The precipitate is washed with IPA and dried, thereby obtaining a dark-red hydrazine-coordinated In chalcogenide complex.

The generation of the hydrazine-coordinated In chalcogenide complex described above can be expressed by a chemical formula (2) shown below.

$$In_2Se_3 + Se \xrightarrow[\text{r.t. for few days}]{N_2H_4} \text{Hydrazinium In-Se precursor} \quad (2)$$

As the chalcogen, Se or S can be used, and Se is preferable. As In, not only In selenide, but also In metal may be used. As the poor solvent, an alcohol solvent is preferable, and IPA is more preferable. As hydrazine, anhydrous hydrazine may be used, although hydrazine monohydrate is preferable. With respect to the amount of In selenide ($In_2Se_3$) and the chalcogen, it is preferable to use 1 mol or more of the chalcogen, per 1 mol of In selenide.

As described above, in the present embodiment, the hydrazine-coordinated In chalcogenide complex is obtained by extracting with a DMSO solution, followed by reprecipitation. As a result, the thus obtained hydrazine-coordinated In chalcogenide complex exhibits improved solubility in a DMSO solution.

Next, the hydrazine-coordinated Ga chalcogenide complex will be described. The hydrazine-coordinated Ga chalcogenide complex used in this embodiment is required to be generated so as to be soluble in DMSO. The hydrazine-coordinated Ga chalcogenide complex can be generated, for example, by adding Ga metal and a chalcogen in hydrazine to obtain a crude product (a second crude product), extracting the crude product with DMSO, adding a poor solvent to the resulting solution, followed by reprecipitation.

More specifically, Ga metal and a chalcogen are added to hydrazine, and stirred at room temperature for about 7 days. Then, hydrazine is removed from the resulting solution while flowing nitrogen to obtain a crude product. Thereafter, the obtained crude product is extracted with DMSO.

Subsequently, the extraction liquid obtained by extracting the crude product is subjected to filtration using, for example, a 0.2 $\mu$m PTFE filter, followed by concentration. Then, a poor solvent is added to the concentrated solution to perform a reprecipitation, and the supernatant is removed. The precipitate is washed with IPA and dried, thereby obtaining a dark-brown hydrazine-coordinated Ga chalcogenide complex.

The generation of the hydrazine-coordinated Ga chalcogenide complex described above can be expressed by a chemical formula (3) shown below.

$$Ga + 2Se \xrightarrow[\text{r.t. for few days}]{N_2H_4} \text{Hydrazinium Ga-Se precursor} \quad (3)$$

As the chalcogen, Se or S can be used, and Se is preferable. As the poor solvent, an alcohol solvent is preferable, and IPA is more preferable. As hydrazine, anhydrous hydrazine may be used, although hydrazine monohydrate is preferable. With respect to the amount of Ga and the chalcogen, it is preferable to use 2 mol or more of the chalcogen, per 1 mol of Ga.

As described above, in the present embodiment, the hydrazine-coordinated Ga chalcogenide complex is obtained by extracting with a DMSO solution, followed by reprecipitation. As a result, the thus obtained hydrazine-coordinated Ga chalcogenide complex exhibits improved solubility in a DMSO solution.

Next, the method of producing the coating solution for forming a CIGS layer will be described.

Firstly, DMSO is added to the aforementioned hydrazine-coordinated Cu chalcogenide complex of the first aspect and stirred at room temperature for about one night, thereby obtaining a DMSO solution having the hydrazine-coordinated Cu chalcogenide complex dissolved therein (solution (I)).

Further, DMSO is added to the aforementioned hydrazine-coordinated In chalcogenide complex and stirred at a temperature of 80 to 120°C for about 1 hour, thereby obtaining a DMSO solution having the hydrazine-coordinated In chalcogenide complex dissolved therein (solution (II)).

Furthermore, DMSO is added to the aforementioned hydrazine-coordinated Ga chalcogenide complex and stirred at a temperature of 80 to 120°C for about 1 hour, thereby obtaining a DMSO solution having the hydrazine-coordinated Ga chalcogenide complex dissolved therein (solution (III)).

Subsequently, the DMSO solution having the hydrazine-coordinated Cu chalcogenide complex dissolved therein, the DMSO solution having the hydrazine-coordinated In chalcogenide complex dissolved therein and the DMSO solution having the hydrazine-coordinated Ga chalcogenide complex dissolved therein are mixed together.

In this manner, the coating solution for forming a light-absorbing layer according to the present embodiment can be produced.

In the coating solution for forming a CIGS layer according to the present embodiment, DMSO is used as the solvent. As a result, the storage stability is improved as compared to a conventional coating solution.

Specifically, when hydrazine is used by a conventional method, a problem arises in that $Cu_2Se$ is precipitated. For example, when hydrazine is used as a solvent, and a solution (I) prepared from $Cu_2S$ and S and a solution (II) prepared from $In_2Se_3$, Ga and Se are mixed together, $Cu_2S$ in the first solution reacts with Se in the second solution to cause the precipitation. The precipitation of $Cu_2S$ was observed after about 2 weeks.

In contrast, the coating solution for forming a light-absorbing layer according to the present embodiment was not deteriorated even after 1 month, meaning that the coating solution exhibited excellent storage stability.

Further, since the coating solution itself does not contain hydrazine, the chemical properties (explosiveness) of hydrazine in the formation of a light-absorbing layer would not be of any problems, thereby improving the safety of the production process.

Furthermore, the coating solution for forming a light-absorbing layer according to the present embodiment contains no amines as a dissolution promoter. As a result, the photovoltaic (PV) performance was improved as compared to conventional coating solutions.

More specifically, when amines are used as a dissolution promoter, the amines remain in the device after formation of the film, thereby deteriorating the PV (photovoltaic) performance. In contrast, since the coating solution for forming a light-absorbing layer according to the present embodiment does not use any amines as a dissolution promoter, the PV performance is not deteriorated.

In the coating solution for forming a light-absorbing layer according to the present embodiment, if desired, a miscible additive may be included as long as the effects of the present invention are not impaired, for example, an organic solvent for adjusting the viscosity, an additive resin for improving the performance of the film, a surfactant for improving the applicability or a stabilizer.

[Second embodiment]

Next, the coating solution for forming a CIGS layer according to a second mode of the present embodiment will be described.

In the present embodiment, the coating solution for forming a light-absorbing layer is prepared from the hydrazine-coordinated Cu chalcogenide complex, the hydrazine-coordinated In chalcogenide complex and the hydrazine-coordinated Ga chalcogenide complex described above in the first embodiment, together with a hydrazine-coordinated Sb chalcogenide complex.

A hydrazine-coordinated Sb chalcogenide complex can be obtained by adding Sb selenide ($Sb_2Se_3$) and a chalcogen to hydrazine to obtain a crude product (a third crude product), extracting the crude product with DMSO, and adding a poor solvent to the resulting solution to perform recrystallization.

More specifically, Sb selenide and a chalcogen are added to hydrazine, and stirred at room temperature for about 3 to 7 days. Then, hydrazine is removed from the resulting solution while flowing nitrogen to obtain a crude product. Thereafter, the obtained crude product is extracted with DMSO.

Subsequently, the extraction solution obtained by extracting the crude product is subjected to filtration using, for example, a 0.2 μm PTFE filter. Then, a poor solvent is added to the filtrate for reprecipitation, thereby obtaining a black hydrazine-coordinated Sb chalcogenide complex.

The generation of the hydrazine-coordinated Sb chalcogenide complex described above can be expressed by a chemical formula (4) shown below.

$$Sb_2Se_3 + Se \xrightarrow[\text{r.t. for few days}]{N_2H_4} \text{Hydrazinium Sb-Se precursor} \quad (4)$$

As the chalcogen, Se or S can be used, and Se is preferable. As the poor solvent, an alcohol solvent is preferable, and IPA is more preferable. As hydrazine, anhydrous hydrazine may be used, although hydrazine monohydrate is preferable. With respect to the amount of Sb selenide ($Sb_2Se_3$) and the chalcogen, it is preferable to use 2 mol or more of the chalcogen, per 1 mol of Sb selenide.

Although the present embodiment is described using Sb selenide, an elemental antimony may also be used instead of Sb selenide. In such a case, with respect to the amount of antimony (Sb) and the chalcogen, it is preferable to use 4 mol or more of the chalcogen, per 1 mol of antimony.

Next, the method of producing the coating solution for forming a CIGS layer according to the present embodiment will be described.

Firstly, DMSO is added to the hydrazine-coordinated Cu chalcogenide complex described in the first embodiment and stirred at room temperature for about one night, thereby obtaining a DMSO solution having the hydrazine-coordinated Cu chalcogenide complex dissolved therein (solution (I')).

Further, DMSO is added to the hydrazine-coordinated In chalcogenide complex and the hydrazine-coordinated Ga chalcogenide complex described in the first embodiment, and stirred at a temperature of 80 to 120°C for about 1 hour, thereby obtaining a DMSO solution having the hydrazine-coordinated In chalcogenide complex and the hydrazine-coordinated Ga chalcogenide complex dissolved therein (solution (II')).

Furthermore, DMSO is added to the aforementioned hydrazine-coordinated Sb chalcogenide complex, and stirred at room temperature for one night, thereby obtaining a DMSO solution having the hydrazine-coordinated Sb chalcogenide complex dissolved therein.

In addition, 2 equivalents of Se is added to $Na_2Se$, and stirred in DMSO at room temperature for 3 to 7 days, thereby obtaining a uniform solution.

In the present embodiment, Na is used for improving the film quality of the light-absorbing layer (e.g., grain size and crystalline quality), and this Na solution may not be used.

Subsequently, the aforementioned 4 solutions, namely, the DMSO solution having the hydrazine-coordinated Cu chalcogenide complex dissolved therein, the DMSO solution having the hydrazine-coordinated In chalcogenide complex and the hydrazine-coordinated Ga chalcogenide complex dissolved therein, the DMSO solution having the hydrazine-coordinated Sb chalcogenide complex dissolved therein and the Na solution are mixed together.

In this manner, the coating solution for forming a light-absorbing layer according to the present embodiment can be produced.

Like in the first embodiment, the coating solution for forming a light-absorbing layer according to the present embodiment is not deteriorated with time, and exhibits excellent storage stability.

Further, since the coating solution itself does not contain hydrazine, the chemical properties (explosiveness) of hydrazine in the formation of a light-absorbing layer would not be of any problems, thereby improving the safety of the production process.

In addition, since the coating solution for forming a light-absorbing layer according to the present embodiment contains no amines as a dissolution promoter, the PV performance is improved as compared to conventional coating solutions.

[Coating solution for forming CZTS layer]

As described above, the hydrazine-coordinated Cu chalcogenide complex according to a first aspect of the present invention is also extremely useful as a Cu component of a coating solution for forming a CZTS layer.

Hereinbelow, the coating solution for forming a CZTS layer according to the present embodiment will be described.

The coating solution of the present embodiment which is used for forming a CZTS layer is obtained by dissolving a hydrazine-coordinated Cu chalcogenide complex component (A), a hydrazine-coordinated Sn chalcogenide complex component (B) and a hydrazine-coordinated Zn chalcogenide complex component (C) in dimethylsulfoxide (DMSO).

The coating solution forming a light-absorbing layer is preferably free of amine solvents.

As the hydrazine-coordinated Cu chalcogenide complex component (A), the hydrazine-coordinated Cu chalcogenide complex of the present invention described above can be used.

Next, the hydrazine-coordinated Sn chalcogenide complex component (B) will be described. The hydrazine-coordinated Sn chalcogenide complex component (B) used in this embodiment is required to be generated so as to be soluble in DMSO. The hydrazine-coordinated Sn chalcogenide complex can be generated, for example, by adding Sn metal and a chalcogen in hydrazine to obtain a crude product, extracting the crude product with DMSO, adding a poor solvent to the resulting solution, followed by reprecipitation.

More specifically, Sn metal and a chalcogen are added to hydrazine, and stirred at room temperature for about 1 to 3 days. Then, hydrazine is removed from the resulting solution while flowing nitrogen to obtain a crude product. Thereafter, the obtained crude product is extracted with DMSO.

Subsequently, the extraction liquid obtained by extracting the crude product is subjected to filtration using, for example, a 0.2 $\mu$m PTFE filter, followed by concentration. Then, a poor solvent is added to the concentrated solution to perform a reprecipitation, and the supernatant is removed. The precipitate is washed with IPA and dried, thereby obtaining a dark-yellow hydrazine-coordinated Sn chalcogenide complex.

Alternatively, the hydrazine-coordinated Sn chalcogenide complex component (B) can be prepared as follows. A metal Sn and 3 equivalents of Se are stirred in hydrazine (5 ml) at room temperature for 1 to 3 days. Then, IPA is added and stirred, and a yellow product is precipitated. The supernatant is removed, and the precipitate is washed with IPA and dried, thereby obtaining a crude product.

Subsequently, the crude product is subjected to extraction with DMSO (80°C, 1 hr), followed by concentration. The resulting concentrated solution is subjected to filtration, thereby obtaining a hydrazine-coordinated Sn-Se complex/DMSO solution.

The generation of the hydrazine-coordinated Sn chalcogenide complex described above can be expressed by a chemical formula (5) shown below.

$$\text{Sn} \ + \ 3\,\text{Se} \ \xrightarrow[\text{r.t. for few days}]{N_2H_4} \ \text{Hydrazinium Sn-Se precursor} \quad (5)$$

As the chalcogen, Se or S can be used, and Se is preferable. As Sn, not only a Sn metal, bu also Sn selenide (SnSe, SnSe$_2$) may be used. As the poor solvent, an alcohol solvent is preferable, and IPA is more preferable. As hydrazine, anhydrous hydrazine may be used, although hydrazine monohydrate or a water-containing hydrazine is preferable. With respect to the amount of Sn and the chalcogen, it is preferable to use 3 mol of the chalcogen, per 1 mol of Sn.

Next, the hydrazine-coordinated Zn chalcogenide complex will be described. The hydrazine-coordinated Zn chalcogenide complex used in this embodiment is required to be generated so as to be soluble in DMSO. The hydrazine-coordinated Zn chalcogenide complex can be generated, for example, by mixing Zn or ZnSe and a chalcogen in the presence of hydrazine to obtain a crude product, followed by extracting the crude product with dimethylsulfoxide.

More specifically, Zn selenide and a chalcogen are added to hydrazine in DMSO, and stirred at room temperature for about 3 to 7 days. Then, hydrazine is removed from the resulting solution while flowing nitrogen to obtain a crude product (reaction intermediate solution). Thereafter, the obtained crude product is extracted with DMSO.

Subsequently, the extraction solution obtained by extracting the crude product is subjected to filtration using, for example, a 0.2 $\mu$m PTFE filter, followed by concentration. The resulting concentrated solution is subjected to filtration, thereby obtaining a hydrazine-coordinated Zn chalcogenide complex.

The generation of the hydrazine-coordinated Zn chalcogenide complex described above can be expressed by a chemical formula (6) shown below.

$$\text{ZnSe} \ + \ 2\text{~}6\,\text{Se} \ + \ 2\text{~}4\,N_2H_4 \ \xrightarrow[\text{r.t. for few days}]{DMSO} \ \text{Hydrazinium Zn-Se precursor} \quad (6)$$

As the chalcogen, Se or S can be used, and Se is preferable. As Zn, not only Zn selenide, but also Zn metal may be used. As hydrazine, anhydrous hydrazine may be used, although hydrazine monohydrate or a water-containing hydrazine is preferable. Further, as the reaction solvent, hydrazine may be used instead of DMSO. With respect to the amount of Zn selenide (ZnSe) and the chalcogen, it is preferable to use 2 mol or more of the chalcogen, per 1 mol of Zn selenide, and it is more preferable to use 3 to 4 mol of the chalcogen, per 1 mol of Zn selenide.

[Method of producing coating solution for forming CZTS layer]

Next, the method of producing the coating solution for forming a light-absorbing layer will be described.

Firstly, DMSO is added to the aforementioned hydrazine-coordinated Cu chalcogenide complex and stirred at room temperature for about one night, thereby obtaining a DMSO solution having the hydrazine-coordinated Cu chalcogenide complex dissolved therein (first solution).

Further, DMSO is added to the aforementioned hydrazine-coordinated Sn chalcogenide complex and stirred at a temperature of 80 to 120°C for about 1 hour, thereby obtaining a DMSO solution having the hydrazine-coordinated Sn chalcogenide complex dissolved therein (second solution).

Further, DMSO is added to the aforementioned hydrazine-coordinated Zn chalcogenide complex and stirred at a temperature of 80 to 120°C for about 1 hour, thereby obtaining a DMSO solution having the hydrazine-coordinated Zn chalcogenide complex dissolved therein (third solution).

Subsequently, the DMSO solution having the hydrazine-coordinated Cu chalcogenide complex dissolved therein, the DMSO solution having the hydrazine-coordinated Sn chalcogenide complex dissolved therein and the DMSO solution having the hydrazine-coordinated Zn chalcogenide complex dissolved therein are mixed together.

In this manner, the coating solution for forming a light-absorbing layer according to the present embodiment can be produced.

The coating solution for forming a light-absorbing layer according to the present embodiment uses DMSO as the solvent, and the coating solution itself does not contain hydrazine. As a result, the chemical properties (explosiveness) of hydrazine in the formation of a light-absorbing layer would not be of any problems, thereby improving the safety of the production process.

Further, since hydrazine-coordinated metal chalcogenide complexes are uniformly dissolved in the solution, storage stability is increased, and the freedom of the choice of the coating apparatus is improved.

Furthermore, the coating solution for forming a light-absorbing layer according to the present embodiment contains no amines as a dissolution promoter. When amines are used as a dissolution promoter, the amines remain in the device after formation of the film, thereby deteriorating the PV (photovoltaic) performance.

In the coating solution for forming a light-absorbing layer according to the present embodiment, if desired, a miscible additive may be included as long as the effects of the present invention are not impaired, for example, an organic solvent for adjusting the viscosity, an additive resin for improving the performance of the film, a surfactant for improving the applicability or a stabilizer.

Next, a method of producing a chalcopyrite solar cell or a CZTS solar cell according to the present embodiment will be described.

The method of producing a chalcopyrite solar cell or a CZTS solar cell according to the present embodiment mainly includes the steps of forming a first electrode on a substrate, forming a light-absorbing layer on the first electrode, forming a buffer layer on the light-absorbing layer, and forming a second electrode on the buffer layer.

In the method, the steps other than the step of forming a light-absorbing layer on the first electrode can be performed by any conventional method. For example, the step of forming a first electrode on a substrate can be performed by a sputtering method using nitrogen as a sputtering gas, and forming a film layer such as an Mo layer. The buffer layer can be formed as a CdS layer by, for example, a chemical bath deposition method. The second electrode can be formed as a transparent electrode using an appropriate material.

In the formation of a light-absorbing layer, firstly, the aforementioned coating solution for forming a light-absorbing layer is applied to the first electrode (support). The application of the coating solution can be conducted by a spin-coat method, a dip-coat method, a doctor-blade (applicator) method, a curtain-slit cast method, a printing method, a spraying method or the like.

The application conditions can be appropriately selected depending on the desired film thickness, concentration of the materials and the like.

For example, in a spin-coating method, the support is set on a spin coater, followed by applying the coating solution to the support. The application conditions can be appropriately selected depending on the film thickness. For example, the application can be performed at a rotation speed of 300 to 3,000 rpm for 10 to 60 seconds.

In a dipping method, the support can be dipped in a container containing the coating solution. The dipping can be performed once, or a plurality of times.

After applying the coating solution for forming a light-absorbing layer on the support, a vacuum drying may be performed.

Subsequently, after applying the coating solution on the support, the support is baked to form a light-absorbing layer.

The baking conditions can be appropriately selected depending on the desired film thickness, the type of materials used, and the like. For example, the baking can be performed in 2 steps, namely, performing a soft bake on a hot plate (prebake), followed by baking in an oven (annealing).

In such a case, for example, the support may be set and held on a hot plate, followed by raising the temperature of the hot plate to 100 to 400°C to perform the soft bake for 1 to 30 minutes. Then, the inside of the oven can be heated to 300 to 600°C, and maintained for 1 to 180 minutes to perform the annealing.

As a result, the light-absorbing layer is cured.

The baking temperatures described above are merely one example of the baking conditions, and the baking conditions are not particularly limited. For example, the temperature of the hot plate can be raised in a stepwise manner, and the heating may be performed in an inert gas atmosphere in a glove box.

Thereafter, the film thickness of the light-absorbing layer is measured. When the film thickness is smaller than the desired thickness, the coating solution for forming a light-absorbing layer is applied to the support again and baked. By repeating these steps, a light-absorbing layer having the desired thickness can be obtained.

In the manner as described above, a chalcopyrite solar cell or a CZTS solar cell according to the present embodiment can be produced. Since the chalcopyrite solar cell produced by the method of the present embodiment contains no hydrazine in the coating solution, the safety of the production process can be improved. Further, since the coating solution for forming a light-absorbing layer exhibits improved storage stability, limitation on the production process can be reduced.

Hereinabove, the present invention has been explained based on the aforementioned embodiments. Needless to say, the present invention is not limited to the aforementioned embodiments, and various modifications can be made without departing from the spirit or scope of the present invention.

For example, in the aforementioned embodiments, although the hydrazine-coordinated Cu chalcogenide complex is obtained by dissolving Cu and a chalcogen in DMSO having hydrazine added thereto, and adding a poor solvent to the resulting solution for recrystallization, the present invention is not limited thereto, and any hydrazine-coordinated Cu chalcogenide complex may be used. It would be satisfactory as long as DMSO having a hydrazine-coordinated Cu chalcogenide complex dissolved therein is ultimately prepared. For example, Cu and a chalcogen may be dissolved in DMSO having hydrazine dissolved therein, and the remaining hydrazine may be removed, so as to use the resulting solution.

Nevertheless, the hydrazine-coordinated Cu chalcogenide complex obtained by recrystallization as described in the aforementioned embodiments exhibits excellent solubility in DMSO. Therefore, by using this complex, a coating solution for forming a light-absorbing layer with a high precision can be obtained as compared to the conventional methods.

EXAMPLES

As follows is a description of examples of the present invention, although the scope of the present invention is by no way limited by these examples.

(Example 1)

In Example 1, a coating solution for forming a CZTS layer was produced as follows.

A metal Cu (383.0 mg, 6.03 mmol) and 2 to 4 equivalents of Se (4 equivalents: 1903.2 mg, 24.10 mmol) were stirred in DMSO (10 ml) at room temperature for 3 days to 1 week in the presence of 2 equivalents of hydrazine relative to the Cu metal (378 $\mu$l, 12.05 mmol). Then, the remaining hydrazine was removed by flowing nitrogen, followed by filtration using a 0.2 $\mu$m PTFE filter.

Thereafter, IPA (total of 20 ml) was gradually added to the filtrate to perform recrystallization, thereby obtaining a black hydrazine-coordinated Cu-Se complex (2,424 mg).

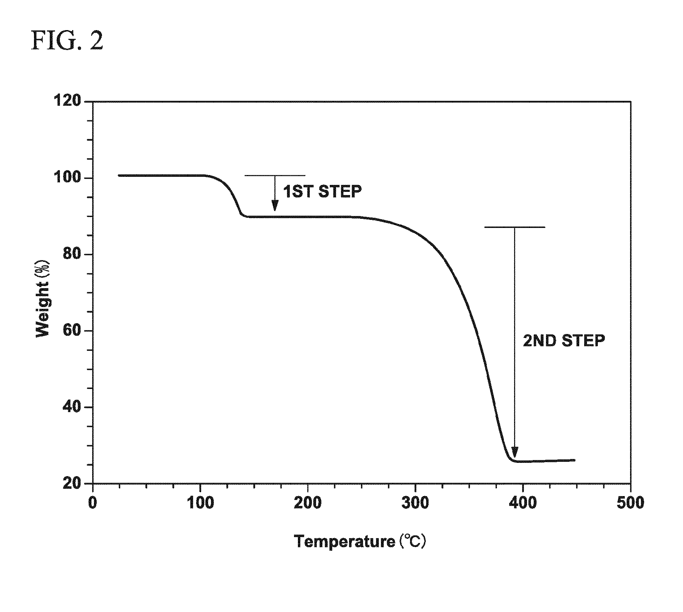

With respect to the obtained hydrazine-coordinated Cu-Se chalcogenide complex, a thermogravimetric analysis (TGA) was performed using TGA 2950 (manufactured by TA Instruments) at a temperature rise rate of 2°C/min. The results are shown in FIG. 2.

As shown in FIG. 2, it was confirmed that in the first step of the weight loss, thermolysis and elimination of the hydrazine ligand contained in the complex occurs and is decomposed, and in the second step, thermolysis and elimination of the selenium ligand occurs, thereby obtaining $Cu_{2-x}Se$ as a final residue.

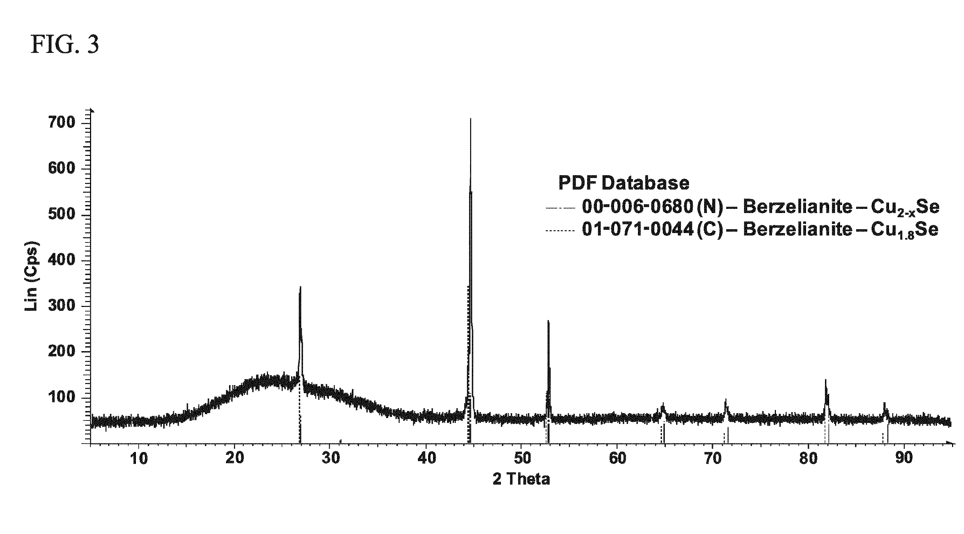

Further, with respect to the $Cu_{2-x}Se$ obtained as the residue in TGA, X-ray diffraction analysis was performed. The results are shown in FIG. 3.

As a result of comparing with the Power Diffraction File (PDF) database, it was confirmed that the thermolysis residue of the TGA was $Cu_{2-x}Se$.

Separately from the above, a metal Sn (356 mg, 3.00 mmol) and 3 equivalents of Se (711mg, 9.00mmol) were stirred in hydrazine (5 ml) at room temperature for 1 to 3 days. Then, the remaining hydrazine was removed by flowing nitrogen, thereby obtaining a crude product. The crude product was extracted with DMSO (80°C, 1 hr), followed by filtering the extraction liquid using a 0.2 $\mu$m PTFE filter. Subsequently, IPA was added and stirred, thereby precipitating a dark-red product. Then, supernatant was removed, and the precipitate was washed with IPA and dried, thereby obtaining a dark-yellow hydrazine-coordinated Sn-Se chalcogenide complex (1016 mg).

Separately from the above, zinc selenide (ZnSe, 460 mg, 4.02 mmol) and 2 to 6 equivalents of Se (5 equivalents: 1588 mg, 20.11 mmol) were stirred in DMSO (8 ml) at room temperature for 3 days to 1 week in the presence of 2 to 4 equivalents of hydrazine relative to ZnSe (3 equivalents: 12.07 mmol). Then, the remaining hydrazine was removed by flowing nitrogen, thereby obtaining a reaction intermediate solution. Subsequently, the reaction intermediate solution was extracted with DMSO at room temperature or under heated conditions (heated condition: 80°C, 1 hr). Then, the extracted liquid was subjected to filtration using a 0.2 $\mu$m PTFE filter, followed by concentration under reduced pressure. The obtained concentrated solution was filtered,

thereby obtaining a hydrazine-coordinated Zn precursor solution.

Subsequently, the hydrazine-coordinated Cu-Se complex, the hydrazine-coordinated Sn-Se complex and the hydrazine-coordinated Zn-Se complex were individually dissolved in DMSO to obtain a hydrazine-coordinated Cu-Se complex/DMSO solution (concentration: 78.4 mg/ml in terms of $Cu_2Se$) (hereafter, referred to as "solution A"), a hydrazine-coordinated Sn-Se complex/DMSO solution (concentration: 178.2 mg/ml in terms of $SnSe_2$) (hereafter, referred to as "solution B") and a hydrazine-coordinated Zn-Se complex/DMSO solution (concentration: 12.4 mg/ml in terms of ZnSe) (hereafter, referred to as "solution C"), respectively.

Thereafter, the solution A (1.904 ml), the solution B (1.255 ml) and the solution C (14.400 ml) were mixed together to prepare a CZTS/DMSO precursor solution.

Application of the coating solution was performed by a dipping method, and the baking was performed by conducting a soft bake on a hot plate at 300°C for 1 minute, followed by closing the hot plate with a lid to perform annealing at 540°C for 10 minutes.

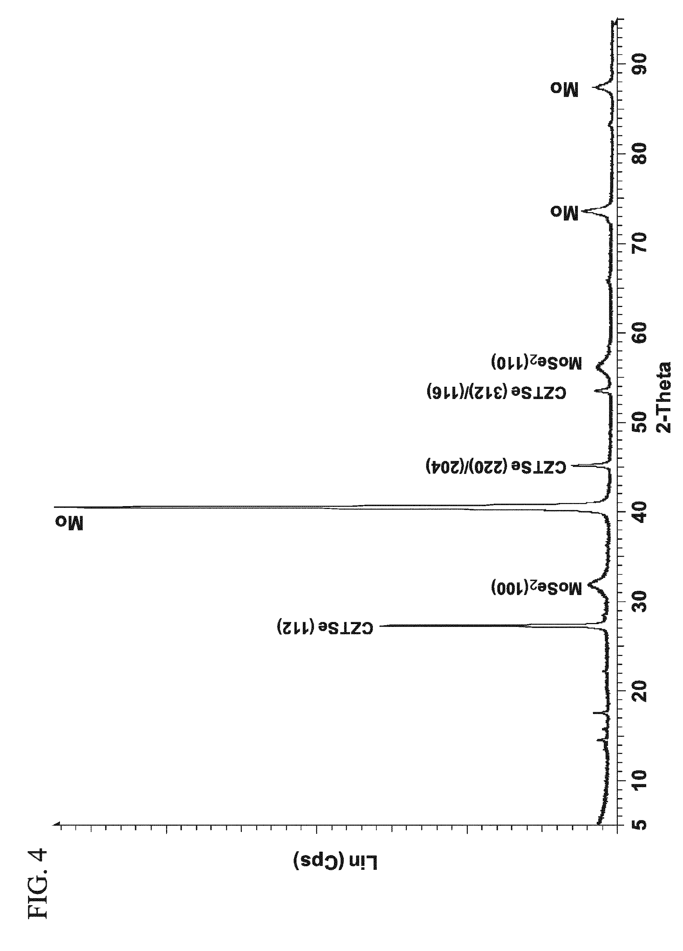

The results of X-ray diffraction analysis (XRD) following formation of the film is shown in FIG. 4.

At about $2\theta = 27°$, $45°$ and 53 to 54°, significant peaks ascribed to CZTS on (112) plane, (220)/(204) plane and (312)/(116) plane were observed, respectively. These results showed good consistency with the XRD analysis results reported in vacuum methods such as a sputtering method ((R. A. Wibowo et al., Journal of Physics and Chemistry of Solids, 68, 1908-1913 (2007))) and a simultaneous deposition method (G. S. Babu et al, Journal of Physics D: Applied Physics, 41, 205305 (2008) and G. S. Babu et al, Semiconductor Science and Technology, 23, 085023 (2008)). Thus, it was confirmed that a CZTS film was formed.

(Example 2)

A hydrazine-coordinated Cu-Se complex, a hydrazine-coordinated Sn-Se complex and a hydrazine-coordinated Zn-Se complex were obtained in the same manner as in Example 1. Subsequently, the hydrazine-coordinated Cu-Se complex, the hydrazine-coordinated Sn-Se complex and the hydrazine-coordinated Zn-Se complex were individually dissolved in DMSO to obtain a hydrazine-coordinated Cu-Se complex/DMSO solution (concentration: 76.3 mg/ml in terms of $Cu_2Se$) (hereafter, referred to as "solution D"), a hydrazine-coordinated Sn-Se complex/DMSO solution (concentration: 98.4 mg/ml in terms of $SnSe_2$) (hereafter, referred to as "solution E") and a hydrazine-coordinated Zn-Se complex/DMSO solution (concentration: 15.9 mg/ml in terms of ZnSe) (hereafter, referred to as "solution F"), respectively.

Subsequently, the solution D (4.412 ml), the solution E (5.00 ml) and the solution F (14.084 ml) were mixed together to obtain a CZTS/DMSO precursor solution (a) (6.95 mg/ml of solid content remaining after baking of 300°C/1 min + 500°C/5 min).

15 ml of the obtained CZTS/DMSO precursor solution (a) was collected, and distilled to remove the solvent, thereby obtaining a CZTS solid mixture. Then, 5 ml of DMSO was added to the CZTS solid mixture, thereby obtaining a concentrated CZTS/DMSO solution (solid content of 100.40 mg/ml remaining after baking of 300°C/1 min + 500°C/5 min).

Application of the coating solution was performed by a spin-coat method, and the baking was performed by conducting a soft bake on a hot plate at 375°C for 1 minute, followed by closing the hot plate with a lid to perform annealing at 540°C for 10 minutes.

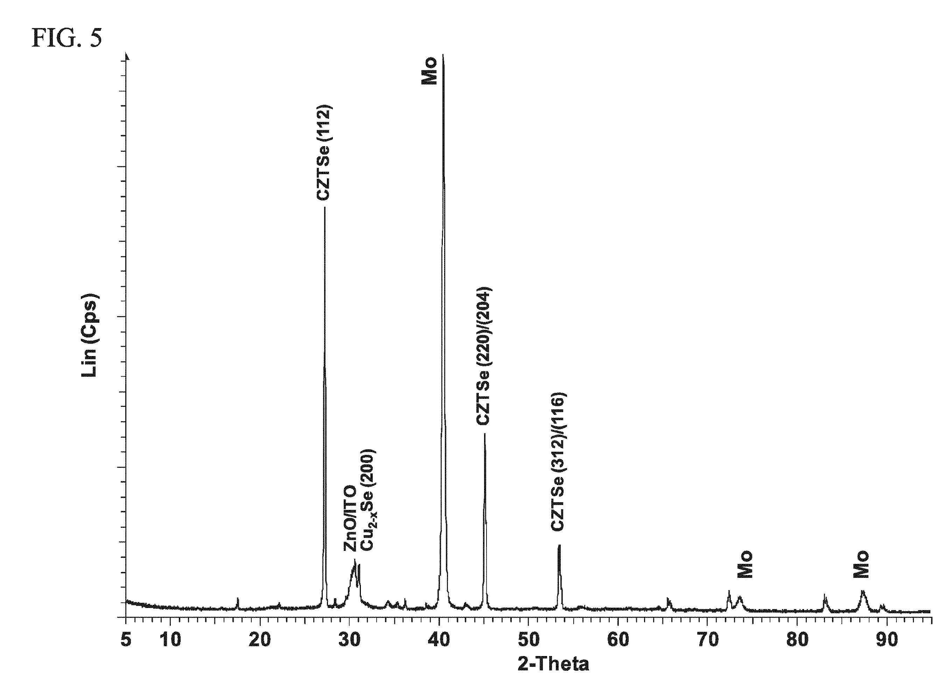

The results of X-ray diffraction analysis (XRD) following formation of the film is shown in FIG. 5.

Like in Example 1, at about $2\theta = 27°$, $45°$ and 53 to 54°, significant peaks ascribed to CZTS on (112) plane, (220)/(204) plane and (312)/(116) plane were observed, respectively. These results showed good consistency with the XRD analysis results reported in vacuum methods such as a sputtering method ((R. A. Wibowo et al., Journal of Physics and Chemistry of Solids, 68, 1908-1913 (2007))) and a simultaneous deposition method (G. S. Babu et al, Journal of Physics D: Applied Physics, 41, 205305

(2008) and G. S. Babu et al, Semiconductor Science and Technology, 23, 085023 (2008)). Thus, it was confirmed that a CZTS film was formed.

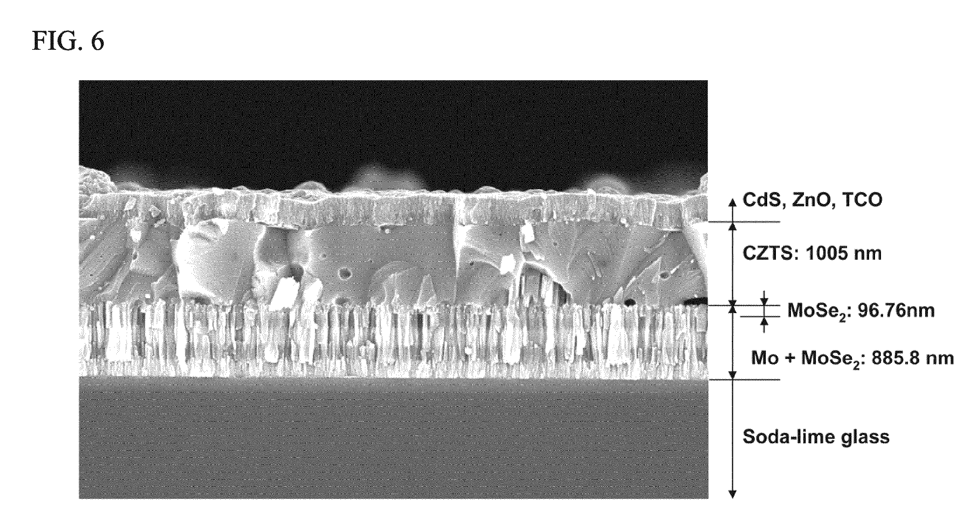

Further, after the formation of the CZTS film, a CdS layer was formed by a chemical bath deposition (CBD) method, and a ZnO layer and a transparent electrode layer (ITO) were formed thereon by a sputtering method. The cross-sectional diagram of the obtained film taken by a scanning electron microscope (SEM) is shown in FIG. 6.

(Example 3)

[Production of metal chalcogen complex]

A Cu metal (383.0 mg, 6.03 mmol) and 4 equivalents of Se (1,903.2 mg, 24.10 mmol) were added to DMSO (10 ml) having 2 equivalents (relative to the amount of Cu metal) of hydrazine anhydride (378 $\mu$l, 12.05 mmol) added thereto, and stirred for 3 days to dissolve the added contents. Then, the remaining hydrazine was removed from the resulting solution while flowing nitrogen, and the solution was then subjected to filtration using a 0.2 $\mu$m PTFE filter. Thereafter, IPA (total of 20 ml) was gradually added to the filtrate to perform recrystallization, thereby obtaining a black hydrazine-coordinated Cu-Se chalcogenide complex (2,424 mg).

Separately from the above, In selenide (964.9 mg, 2.07 mmol) and 1 equivalent of Se (1,645.2 mg, 2.07 mmol) were added to hydrazine anhydride (5 ml), followed by stirring at room temperature for 3 days. Then, the remaining hydrazine was removed from the resulting solution while flowing nitrogen to obtain a crude product. Subsequently, the crude product was extracted with DMSO, and the extraction liquid was subjected to filtration using a 0.2 μm PTFE filter, followed by concentration. Thereafter, IPA was added to the concentrated solution, followed by stirring to precipitate a dark-red product. Then, supernatant was removed, and the precipitate was washed with IPA and dried, thereby obtaining a dark-red hydrazine-coordinated In-Se chalcogenide complex (838.2 mg).

Separately from the above, a Ga metal (418.3 mg, 6.00 mmol) and 2 equivalents of Se (947.5 mg, 12.00 mmol) were added to hydrazine anhydride (5 ml), followed by stirring at room temperature for 1 week. Then, the remaining hydrazine was removed from the resulting solution while flowing nitrogen to obtain a crude product. Subsequently, the crude product was extracted with DMSO, and the extraction liquid was subjected to filtration using a 0.2 μm PTFE filter, followed by concentration. Thereafter, IPA (20 ml) was added to the concentrated solution, followed by stirring to precipitate a brownish product. Then, supernatant was removed, and the precipitate was washed with IPA and dried, thereby obtaining a dark-brown hydrazine-coordinated Ga-Se chalcogenide complex (428.7 mg).

Separately from the above, antimony (III) selenide ($Sb_2Se_3$; 1208.3 mg, 2.51 mmol) and 2 equivalents of Se (397.3 mg, 5.03 mmol) were stirred in hydrazine (5ml) at room temperature for 3 days to 1 week. Then, the remaining hydrazine was removed by flowing nitrogen, thereby obtaining a crude product. Subsequently, the obtained product was extracted with DMSO (DMSO 5 ml x 2), and the extraction liquid was subjected to filtration using a 0.2 μm PTFE filter. Thereafter, IPA (total: 10 ml) was gradually added to the filtrate to perform recrystallization, thereby obtaining a black hydrazine-coordinated Sb-Se chalcogenide complex (90 mg).

[Production of CIGS coating solution]

To the hydrazine-coordinated Cu-Se complex (170.9 mg) prepared and separated in the manner described above was added DMSO (2.6 ml), followed by stirring at room temperature for one night, thereby obtaining a hydrazine-coordinated Cu-Se complex/DMSO solution (hereafter, referred to as "solution G").

To the hydrazine-coordinated In-Se complex (178.5 mg) prepared and separated in the manner described above was added DMSO (2.3 ml), followed by stirring at 80 to 120°C for 1 hour, thereby obtaining a hydrazine-coordinated In-Se complex/DMSO solution (hereafter, referred to as "solution H").

To the hydrazine-coordinated Ga-Se complex (98.9 mg) prepared and separated in the manner described above was added DMSO (1.5 ml), followed by stirring at 80 to 120°C for 1 hour, thereby obtaining a hydrazine-coordinated Ga-Se complex/DMSO solution (hereafter, referred to as "solution I").

Thereafter, the solution G (2.61 ml), the solution H (1.98 ml) and the solution I (0.77 ml) were mixed together to obtain a CIGS/DMSO precursor solution.

(Example 4)

[Production of CIGS coating solution]

To the hydrazine-coordinated Cu-Se complex (2,167 mg) prepared and separated in [Production of metal chalcogen complex] in Example 3 was added DMSO (12.6 ml), followed by stirring at room temperature for one night, thereby obtaining a hydrazine-coordinated Cu-Se complex/DMSO solution (hereafter, referred to as "solution J").

To the hydrazine-coordinated In-Se complex (2,376 mg) and the hydrazine-coordinated Ga-Se complex (629 mg) prepared and separated in [Production of metal chalcogen complex] in Example 3 was added DMSO (11.23 ml), followed by stirring at 80 to 120°C for 1 hour, thereby obtaining a hydrazine-coordinated In-Se complex + hydrazine-coordinated Ga-Se complex/DMSO solution (hereafter, referred to as "solution K").

To the hydrazine-coordinated Sb-Se complex (11 mg) prepared and separated in [Production of metal chalcogen complex] in Example 3 was added DMSO (1.5 ml), followed by stirring at room temperature for one night, thereby obtaining a hydrazine-coordinated Sb-Se complex/DMSO solution (hereafter, referred to as "solution L").

In addition, $Na_2Se$ (255.4 mg, 2.04 mmol) was added to 2 equivalents of Se (322.8 mg, 4.09 mmol), and stirred in DMSO (10 ml) at room temperature for 3 days to 1 week, thereby obtaining a uniform black solution (hereafter, referred to as "solution M").

Thereafter, the solution J (12.120 ml), the solution K (11.230 ml), the solution L (2.711 ml) and the solution M (0.014 ml) were mixed together to obtain a CIGS/DMSO precursor solution.

[Production of solar cell]

(Example 5)

The hydrazine-coordinated Cu-Se complex, the hydrazine-coordinated In-Se complex and the hydrazine-coordinated Ga-Se complex prepared and separated in [Production of metal chalcogen complex] in Example 3 were dissolved in DMSO to produce a coating solution for forming a light-absorbing layer.

The coating solution was adjusted to a CIGS/DMSO solution having a concentration of 0.3 mol/l, and the mixing molar ratio was adjusted to Cu/(In+Ga) = 0.92, In/(In+Ga) = 0.72, and Ga/(In+Ga) = 0.28.

Further, the amount of Sb was adjusted to Sb/(Cu+In+Ga)x100 = 0.1 mol%, and the amount ofNa was adjusted to Na/(Cu+In+Ga) x100 = 0.05 mol%.

Application of the coating solution was performed by a spin-coating method, and the baking was performed by conducting a soft bake at 300°C for 5 minutes, followed by annealing at 540°C for 5 minutes.

A solar cell was produced so that an Mo layer, a CIGS layer (light-absorbing layer), a CdS layer, an i-ZnO layer, an ITO layer, an Al layer, an Ni layer and an $MgF_2$ layer were laminated on a substrate in this order.

The results of the device evaluation of the produced solar cell are shown in Table 1.

(Example 6)

In Example 6, a coating solution for forming a light-absorbing layer was produced in the same manner as in Example 5, except that in [Production of metal chalcogen complex] in Example 3, hydrazine monohydrate was used instead of anhydrous hydrazine in the production of the hydrazine-coordinated Cu-Se complex and the hydrazine-coordinated Ga-Se complex

Application of the coating solution was performed by a spin-coating method, and the baking was performed by conducting a soft bake at 300°C for 5 minutes, followed by annealing at 600°C for 5 minutes.

A solar cell was produced so that an Mo layer, a CIGS layer (light-absorbing layer), a CdS layer, an i-ZnO layer, an ITO layer and an Al-Ni layer were laminated on a substrate in this order.

The results of the device evaluation of the produced solar cell are shown in Table 1.

(Comparative Example 1)

In Comparative Example 1, a hydrazine-coordinated Cu-Se complex, a hydrazine-coordinated In-Se complex and a hydrazine-coordinated Ga-Se complex were obtained as crude products without performing reprecipitation or recrystallization. The crude products were dissolved in a DMSO solution having monoethanolamine added thereto, thereby obtaining a coating solution for forming a light-absorbing layer.

The coating solution was adjusted to a CIGS-DMSO/monoethanolamine solution (3:1) having a concentration of 0.1 mol/l, and the mixing molar ratio was adjusted to Cu/(In+Ga) = 0.92, In/(In+Ga) = 0.72, and Ga/(In+Ga) = 0.28.

Application of the coating solution was performed by a spin-coating method, and the baking was performed by conducting a soft bake at 170°C for 5 minutes, a further soft bake at 190°C for 5 minutes, followed by annealing at 490°C for 30 minutes.

A solar cell was produced so that an Mo layer, a CIGS layer (light-absorbing layer), a CdS layer, an i-ZnO layer, an ITO layer, an Al-Ni layer and an $MgF_2$ layer were laminated on a substrate in this order.

The results of the device evaluation of the produced solar cell are shown in Table 1.

(Comparative Example 2)

In Comparative Example 2, a hydrazine-coordinated Cu-Se complex, a hydrazine-coordinated In-Se complex and a hydrazine-coordinated Ga-Se complex were obtained as crude products without performing reprecipitation or recrystallization. Then, the crude products were added to a DMSO solution. However, the hydrazine-coordinated In-Se complex and the hydrazine-coordinated Ga-Se complex could not be satisfactorily dissolved in the DMSO solution, and compounds were deposited. As a result, a coating solution for forming a light-absorbing layer could not be produced.

[Table 1]

| Evaluation conditions | Conversion efficiency (%) | FF(%) | Voc (mV) | Jsc (mA/cm2) | Rs (Ω) | Rsh (Ω) |
|---|---|---|---|---|---|---|
| Ex. 5 | 6.03 | 56.5 | 417 | 25 | 7.7 | 502 |
| Ex. 6 | 6.76 | 58.4 | 490 | 23.8 | 9.6 | 432 |

(continued)

| Evaluation conditions | Conversion efficiency (%) | FF(%) | Voc (mV) | Jsc (mA/cm2) | Rs (Ω) | Rsh (Ω) |
|---|---|---|---|---|---|---|
| Comp. Ex. 1 | 0.21 | 36.7 | 0.193 | 3.022 | 67.4 | 305.3 |

In Table 1, "FF" indicates the fill factor, which is a value obtained by dividing the maximum power of the solar cell by (open circuit voltage x short-circuit current). Voc indicates the open circuit voltage, which is the voltage obtained when the terminal is opened during irradiation of light, i.e., the maximum voltage of the solar cell. Jsc indicates the short-circuit current, which is the current obtained when the terminal is short-circuited during irradiation of light, i.e., the maximum current of the solar cell. Rs indicates the series resistance, and Rsh indicates the shunt resistance.

In Examples 5 and 6, solar cell properties were confirmed, and hence, it was confirmed that the hydrazine-coordinated Cu complex of the present invention can be used as a precursor for forming a light-absorbing layer of a CIGS solar cell.

Further, in Comparative Example 1, solar cell efficiency was deteriorated by the addition of an amine. Thus, it was confirmed that it is preferable not to add amines.

(Example 7)

A hydrazine-coordinated Cu-Se complex, a hydrazine-coordinated Sn-Se complex and a hydrazine-coordinated Zn-Se complex were obtained in the same manner as in Example 1. Then, the hydrazine-coordinated Cu-Se complex, the hydrazine-coordinated Sn-Se complex and the hydrazine-coordinated Zn-Se complex were dissolved in DMSO to prepare a coating solution for forming a light-absorbing layer.

The coating solution was prepared so as to have a mixing ratio of Cu/(Zn + Sn) = 0.81 and Zn/Sn = 1.22.

Application of the coating solution was performed by a spin-coating method, and the baking was performed by conducting a soft bake at 325°C for 1 minute, followed by annealing at 459°C for 10 minutes.

A solar cell was produced so that an Mo layer, a CZTS layer (light-absorbing layer), a CdS layer, a ZnO layer, an ITO layer, an Ni-Al layer and $MgF_2$ were laminated on a substrate in this order.

The results of the device evaluation of the produced solar cell are shown in Table 2.

[Table 2]

| Evaluation conditions | Conversion efficiency (%) | FF(%) | Voc (mV) | Jsc (mA/cm2) | Rs (Ω) | Rsh (Ω) |
|---|---|---|---|---|---|---|
| Ex. 7 | 2.30 | 44.0 | 258.0 | 20.3 | 9.5 | 110.5 |

In Examples 7, solar cell properties were confirmed, and hence, it was confirmed that the hydrazine-coordinated Cu complex of the present invention can be used as a precursor for forming a light-absorbing layer of a CIGS solar cell.

[Description of Reference Symbols]

1:    Solar cell
2:    Substrate
3:    First electrode
4:    CZTS layer (light absorbing layer)
5:    Buffer layer
6:    i-ZnO layer
7:    Second electrode

**Claims**

1.    A hydrazine-coordinated Cu chalcogenide complex obtainable by reacting Cu or $Cu_2Se$ and a chalcogen in dimethylsulfoxide in the presence of hydrazine and free of an amine solvent, and adding a poor solvent to the resulting solution or subjecting the resulting solution to concentration and filtration.

2.    The hydrazine-coordinated Cu chalcogenide complex according to Claim 1, wherein the poor solvent is an alcohol solvent.

3. The hydrazine-coordinated Cu chalcogenide complex according to Claim 1 or 2, wherein the chalcogen is sulfur or selenium.

4. A method of producing a hydrazine-coordinated Cu chalcogenide complex, comprising:

reacting Cu or $Cu_2Se$ and a chalcogen in dimethylsulfoxide in the presence of hydrazine and free of an amine solvent, and adding a poor solvent to the resulting solution or subjecting the resulting solution to concentration and filtration.

5. The method according to Claim 4, wherein the poor solvent is an alcohol solvent.

6. The method according to Claim 4 or 5, wherein the chalcogen is sulfur or selenium.

7. A coating solution for forming a light-absorbing layer of a chalcopyrite solar cell, comprising a hydrazine-coordinated Cu chalcogenide complex of any one of Claims 1 to 3, a hydrazine-coordinated In chalcogenide complex and a hydrazine-coordinated Ga chalcogenide complex dissolved in dimethylsulfoxide.

8. The coating solution according to Claim 7, which is free of amine solvents.

9. The coating solution according to any one of Claims 7 or 8, wherein the hydrazine-coordinated In chalcogenide complex is obtained by adding In or $In_2Se_3$ and a chalcogen to hydrazine to obtain a crude product, extracting the crude product with dimethylsulfoxide, and adding a poor solvent to the resulting solution.

10. The coating solution according to any one of Claims 7 to 9, wherein the hydrazine-coordinated Ga chalcogenide complex obtained by adding Ga and a chalcogen to hydrazine to obtain a crude product, extracting the crude product with dimethylsulfoxide, and adding a poor solvent to the resulting solution.

11. The coating solution according to any one of Claims 7 to 10, wherein the poor solvent is an alcohol solvent.

12. The coating solution according to any one of Claims 7 to 11, wherein the chalcogen is sulfur or selenium.

13. A method of producing a coating solution forming a light-absorbing layer of a chalcopyrite solar cell, the method comprising: dissolving a hydrazine-coordinated Cu chalcogenide complex of any one of Claims 1 to 3, a hydrazine-coordinated In chalcogenide complex and a hydrazine-coordinated Ga chalcogenide complex in dimethylsulfoxide.

14. The method according to Claim 13, which comprises:

dissolving a hydrazine-coordinated Cu chalcogenide complex of any one of Claims 1 to 3 in dimethylsulfoxide to obtain a solution (I),
dissolving a hydrazine-coordinated In chalcogenide complex in dimethylsulfoxide to obtain a solution (II),
dissolving a hydrazine-coordinated Ga chalcogenide complex in dimethylsulfoxide to obtain a solution (III), and
mixing together the solution (I), the solution (II) and the solution (III).

15. The method according to Claim 13, which comprises:

dissolving a hydrazine-coordinated Cu chalcogenide complex of any one of Claims 1 to 3 in dimethylsulfoxide to obtain a solution (I'),
dissolving a hydrazine-coordinated In chalcogenide complex and a hydrazine-coordinated Ga chalcogenide complex in dimethylsulfoxide to obtain a solution (II'), and
mixing together the solution (I') and the solution (II').

16. The method according to any one of Claims 13 to 15, wherein the hydrazine-coordinated In chalcogenide complex is obtained by adding In or $In_2Se_3$ and a chalcogen to hydrazine to obtain a crude product, extracting the crude product with dimethylsulfoxide, and adding a poor solvent to the resulting solution.

17. The method according to any one of Claims 13 to 16, wherein the hydrazine-coordinated Ga chalcogenide complex obtained by adding Ga and a chalcogen to hydrazine to obtain a crude product, extracting the crude product with dimethylsulfoxide, and adding a poor solvent to the resulting solution.

**18.** The method according to any one of Claims 13 to 17, wherein the poor solvent is an alcohol solvent.

**19.** The method according to any one of Claims 13 to 18, wherein the chalcogen is sulfur or selenium.

FIG. 1

FIG. 2

FIG. 3

EP 2 706 578 A1

FIG. 4

EP 2 706 578 A1

FIG. 5

FIG. 6

CdS, ZnO, TCO

CZTS: 1005 nm

MoSe$_2$: 96.76nm

Mo + MoSe$_2$: 885.8 nm

Soda-lime glass

EP 2 706 578 A1

## INTERNATIONAL SEARCH REPORT

| | International application No. |
|---|---|
| | PCT/JP2012/064799 |

### A. CLASSIFICATION OF SUBJECT MATTER
*H01L31/04*(2006.01)i

According to International Patent Classification (IPC) or to both national classification and IPC

### B. FIELDS SEARCHED

Minimum documentation searched (classification system followed by classification symbols)
H01L31/04-31/078, H01L21/208, H01L21/368

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X<br>Y | US 6379585 B1 (Aron Vecht, David Williams),<br>30 April 2002 (30.04.2002),<br>entire text; all drawings<br>& GB 9711799 A          & EP 1003690 A1<br>& WO 1998/055395 A1 | 1-6<br>7-19 |
| X<br>A | JP 2010-530624 A (International Business<br>Machines Corp.),<br>09 September 2010 (09.09.2010),<br>entire text; all drawings<br>& US 2008/0314738 A1      & EP 2176896 A1<br>& WO 2008/155251 A1      & KR 10-2009-0119837 A<br>& CN 101681993 A | 1-3<br>4-19 |

☒ Further documents are listed in the continuation of Box C.　　　☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 27 June, 2012 (27.06.12) | 10 July, 2012 (10.07.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

23

EP 2 706 578 A1

**INTERNATIONAL SEARCH REPORT**

International application No.

PCT/JP2012/064799

C (Continuation). DOCUMENTS CONSIDERED TO BE RELEVANT

| Category* | Citation of document, with indication, where appropriate, of the relevant passages | Relevant to claim No. |
|---|---|---|
| Y<br>A | JP 2011-91228 A (Fuji Film Kabushiki Kaisha),<br>06 May 2011 (06.05.2011),<br>entire text; all drawings<br>(Family: none) | 7-19<br>1-6 |
| A | JP 2005-51224 A (International Business<br>Machines Corp.),<br>24 February 2005 (24.02.2005),<br>entire text; all drawings<br>& US 2005/0009229 A1    & KR 10-2005-0007120 A<br>& CN 1595677 A      & TWB 00I297905 | 1-19 |

Form PCT/ISA/210 (continuation of second sheet) (July 2009)

REFERENCES CITED IN THE DESCRIPTION

**Patent documents cited in the description**

- US 157885 A
- US 13157922 A
- US 7094651 B
- WO 2008057119 A
- WO 2008063190 A
- US 7517718 B
- US 7341917 B
- US 7618841 B
- US 20090145482 A

**Non-patent literature cited in the description**

- **R. A. WIBOWO et al.** *Journal of Physics and Chemistry of Solids,* 2007, vol. 68, 1908-1913
- **G. S. BABU et al.** *Journal of Physics D: Applied Physics,* 2008, vol. 41, 205305
- **G. S. BABU et al.** *Semiconductor Science and Technology,* 2008, vol. 23, 085023